(19) Europäisches Patentamt

European Patent Office

Office européen des brevets

(11) **EP 0 709 963 B1**

(12) **FASCICULE DE BREVET EUROPEEN**

(45) Date de publication et mention
de la délivrance du brevet:
**22.12.1999 Bulletin 1999/51**

(51) Int Cl.6: **H03K 17/693**, H03K 17/00,
H03K 17/62

(21) Numéro de dépôt: **95402405.5**

(22) Date de dépôt: **26.10.1995**

(54) **Multiplexeurs CMOS de variables logiques**

CMOS-Multiplexer für logische Variablen

CMOS multiplexers of logic variables

(84) Etats contractants désignés:
**CH DE FR GB LI**

(30) Priorité: **28.10.1994 FR 9412990**

(43) Date de publication de la demande:
**01.05.1996 Bulletin 1996/18**

(73) Titulaire: **C.S.E.M.**
**CENTRE SUISSE D'ELECTRONIQUE ET DE**
**MICROTECHNIQUE S.A.**
**2007 Neuchâtel (CH)**

(72) Inventeurs:
• **Piguet, Christian**
**CH-2000 Neuchatel (CH)**
• **Masgonty, Jean-Marc**
**CH-2035 Corcelles (CH)**

(74) Mandataire: **Colas, Jean-Pierre et al**
**Cabinet de Boisse et Colas**
**37, avenue Franklin D. Roosevelt**
**75008 Paris (FR)**

(56) Documents cités:
**US-A- 4 593 390**       **US-A- 5 012 126**

• **IBM TECHNICAL DISCLOSURE BULLETIN, vol.**
**27, no. 1b, Juin 1984 NEW YORK US, pages**
**65-66, GRIFFIN ET AL 'cmos select one out of n**
**multiplexer'**
• **IBM TECHNICAL DISCLOSURE BULLETIN, vol.**
**27, no. 2, Juillet 1984 NEW YORK US, pages**
**988-989, GRIFFIN ET AL 'select one out of n**
**multiplexer'**
• **P.HOROWITZ & W.HILL: "The Art of**
**Electronics", Cambridge University Press, 1980,**
**Cambridge, US; pages 325-327**

## Description

La présente invention est relative à des multiplexeurs de variables logiques et, plus particulièrement, à des multiplexeurs à deux entrées et une sortie et à des multiplexeurs à nombre d'entrées supérieur à 2 et constitués d'un agencement arborescent de tels multiplexeurs à deux entrées.

On connaît dans la technique, le multiplexeur à deux entrées $I_0, I_1$ et une sortie Q représenté à la figure IA du dessin annexé. Dans ce multiplexeur connu, la variable appliquée à chaque entrée $I_0, I_1$ est traitée dans un inverseur 1,2, respectivement, à sortie commandée par un signal de commande S du multiplexeur ou par le complément logique de ce signal, les sorties de ces deux inverseurs passant aussi sélectivement dans un troisième inverseur 3 à la sortie duquel on retrouve l'image de la variable appliquée à $I_0$ ou à $I_1$, suivant l'état de la variable de commande S.

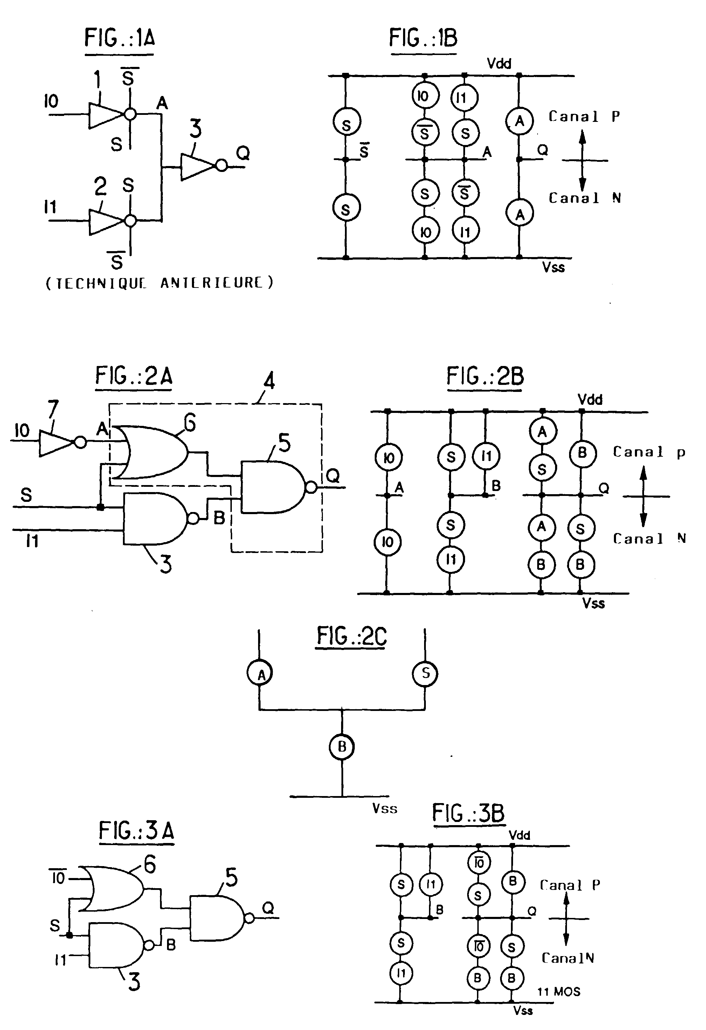

On a représenté à la figure 1B une topographie de transistors exécutant les fonctions logiques visibles sur la figure 1A, en technologie C2MOS. Chaque transistor est représenté par un cercle entourant la variable commandant la conduction dudit transistor, soit S, , A, sortie des inverseurs 1 et 2 de la figure 1A, $I_0$ ou $I_1$, variables d'entrée. Les transistors sont groupés suivant leur type, canal P ou canal N, et sont connectés "en branches" parallèles, entre une des bornes $V_{DD}$, $V_{SS}$ d'une source d'alimentation électrique et les noeuds de sortie des variables , A et Q.

On reconnaît ainsi sur la topographie de la figure 1B un inverseur constitué par les deux transistors S montés en série entre $V_{DD}$ et $V_{SS}$, la borne commune de ces transistors délivrant classiquement . On reconnaît de même l'inverseur 3 constitué par les deux transistors A, qui délivre la sortie Q en inversant le signal A. Les inverseurs 1 et 2 sont constitués respectivement par la branche contenant les transistors $I_0$, canal P, connectée en série avec les transistors S, $I_0$ canal N et par la branche contenant les transistors S et $I_1$ canal P, connectée en série avec les transistors ,$I_1$ canal N, entre les deux bornes $V_{DD}$ et $V_{SS}$ de la source d'alimentation.

La structure "en branches" de cette topographie est favorable du point de vue de la compacité du circuit intégré ainsi conçu et donc du point de vue de l'abaissement de sa consommation électrique. Cependant, on observe que le transfert d'une variable d'entrée $I_0$ ou $I_1$ à la sortie Q du multiplexeur implique les transitions en série de trois "portes" désignées par la variable qu'elles délivrent, soit la porte constituée des deux transistors S situés à gauche de la figure 1B, la porte A constituée par les huit transistors situés au centre sur cette figure et la porte Q constituée par les deux transistors A à droite de la figure. Ces trois transitions impliquent donc trois "délais" ou retard qui se cumulent, ce qui n'est pas favorable du point de vue de la rapidité du circuit. En outre, on remarque que la porte A est tirée à 1 à travers deux transistors MOS canal P dont on sait qu'il ne sont pas très rapides.

Le même inconvénient peut être trouvé dans le circuit décrit dans le document US 4 593 390 dans lequel est décrit un multiplexeur qui, si on opère les transformations selon la loi de Morgan (exposées par exemple dans l'ouvrage de P. HOROWITZ & W. HILL dans "The Art of Electronics" Cambridge University Press, 1980, Cambridge, US; pages 325 à 327), peut être schématisé de la même façon que le multiplexeur représenté aux figures 1A et 1B.

La présente invention a pour but de réaliser des multiplexeurs de variables logiques dans lesquels aucun inverseur n'est nécessaire pour la variable de commande, de sorte que l'on peut supprimer un délai, augmentant ainsi la rapidité de fonctionnement des multiplexeurs, ceux-ci présentant ainsi une haute fréquence de fonctionnement ou une basse consommation d'énergie électrique, ou assurant un compromis satisfaisant entre ces deux caractéristiques antagonistes.

On atteint ce but de l'invention, ainsi que d'autres qui apparaîtront à la lecture de la description qui va suivre, avec un multiplexeur réalisé selon l'une des revendications 1 à 4 indépendantes.

Les avantages de l'invention sont ainsi obtenus grâce à un agencement en branches particulier des transistors composant le multiplexeur selon l'invention.

Comme on le verra dans la suite, ces structures du multiplexeur ne font usage que de la forme "vraie" du signal de commande. On évite ainsi le délai nécessaire à l'inversion de celui-ci et on gagne donc en rapidité. C'est la un avantage important notamment dans des circuits à basse consommation que l'on souhaite faire fonctionner cependant à des fréquences élevées.

La présente invention permet encore de réaliser un multiplexeur à $2^n$ entrées logiques et une sortie conformément aux sous-revendications 5 à 8. Ce multiplexeur comporte n étages de multiplexeurs à deux entrées et une sortie, les multiplexeurs d'un même étage i étant commandés par le ième bit d'un mot de commande de n bits et ces multiplexeurs étant connectés suivant une arborescence, au moins l'un de ceux-ci étant constitué par un multiplexeur à deux entrées et une sortie suivant la présente invention.

D'autres caractéristiques et avantages des multiplexeurs suivant la présente invention apparaîtront à la lecture de la description qui va suivre et à l'examen du dessin annexé dans lequel :

- les figures 1A et 1B illustrent un multiplexeur de la technique antérieure, déjà décrit en préambule de la présente description,
- les figures 2A à 2C illustrent un premier mode de réalisation d'un multiplexeur à deux entrées et une sortie suivant la présente invention,
- les figures 3A et 3B, 4, 5A à 5C, 6A et 6B, représentent d'autres modes de réalisation d'un multiplexeur à deux entrées et une sortie suivant la présente invention,

- la figure 7 illustre schématiquement une structure de multiplexeur à quatre entrées et une sortie suivant la présente invention,
- les figures 8A et 9 illustrent des variantes de multiplexeurs de quatre entrées vers une sortie suivant la présente invention, et
- les figures 10A, 10B et 11A, 11B illustrent des structures de multiplexeurs de trois entrées vers une sortie suivant la présente invention.

On se réfère à la figure 2 du dessin annexé où l'on a représenté un premier mode de réalisation d'un multiplexeur suivant l'invention, comprenant deux entrées $I_0$ et $I_1$ et une sortie Q. Ce multiplexeur est constitué essentiellement de deux portes logiques 3 et 4. La porte 3 exécute une première fonction logique élémentaire faisant intervenir l'entrée $I_1$ et une variable de commande S du multiplexeur. Dans le mode de réalisation représenté à la figure 2, cette première fonction logique élémentaire est la fonction NAND.

La deuxième porte exécute une fonction logique plus complexe faisant intervenir l'autre entrée $I_0$, la variable de commande S et la sortie B de la porte 3. La deuxième porte 4 est ainsi constituée de deux portes logiques élémentaires 5 et 6, la porte 5 exécutant la même fonction logique NAND que la porte 3. La porte logique élémentaire 6 est une porte OR combinant le complément logique de l'entrée $I_0$ et la variable de commande S. Ce complément logique est obtenu à partir d'un inverseur 7 intégré au multiplexeur. Dans certaines circonstances cet inverseur peut être omis comme on le verra plus loin. Dans la suite de la présente description, les portes 3, 4 et 7 seront désignées par les variables qu'elles délivrent soit B, Q et A respectivement.

On a représenté à la figure 2B une topographie de transistors CMOS mettant en oeuvre la structure de multiplexeurs schématisée à la figure 2A. On retrouve la disposition classique en deux groupes des transistors, canal P et canal N respectivement, déjà utilisée sur la figure 1B. Les noeuds de sortie A, B, Q communs à chaque paire de groupes de types opposés, correspondent aux sorties des trois portes définies en liaison avec la figure 2A. C'est ainsi qu'on retrouve l'inverseur A dans les deux transistors $I_0$ canal P et canal N respectivement, disposés en série entre les bornes $V_{DD}$, $v_{SS}$ de la source d'alimentation électrique. La porte B est constituée d'un premier groupe de transistors canal P comprenant un transistor S en parallèle avec un transistor $I_1$ et d'un deuxième groupe de transistors canal N composé de transistors S et $I_1$ en série. La porte Q est composée d'un premier groupe de transistors canal P comportant un transistor B en parallèle avec une branche comprenant un transistor A et un transistor S en série, et d'un deuxième groupe de transistors canal N formé d'une première branche comptant un transistor A et un transistor B en série, cette branche étant en parallèle avec une deuxième branche comprenant un transistor S en série avec un transistor B.

On constate que cette topographie compte treize transistors MOS alors que celle de la technique antérieure représentée à la figure 1B n'en compte que douze. Il est clair cependant que le nombre de transistors de la topographie de la figure 2B pourrait être ramené à douze en remplaçant les deux transistors B placés dans des branches parallèles par un transistor B unique, comme représenté à la figure 2C. Surtout, on remarque que le délai entre l'entrée de la variable de commande S et la sortie Q est constitué par le cumul des temps de transition de deux portes au maximum, celui de la porte B et celui de la porte Q, alors que le délai correspondant du multiplexeur des figures 1A, 1B est constitué par les temps de transition de trois portes. Le multiplexeur suivant l'invention est donc plus rapide, à consommation égale, que celui des figures 1A, 1B.

En outre, une analyse détaillée sur une table d'états du circuit de la figure 2B montre qu'il ne comporte qu'une seule course (entre les portes B et Q), introduisant des variations transitoires parasites des niveaux de tension lus sur la sortie Q, niveaux qui doivent normalement être égaux soit à $V_{DD}$ soit à $V_{SS}$. On évite ces variations très simplement, suivant l'invention, en faisant en sorte que l'une des portes transite plus rapidement que l'autre. Dans le cas présent, la porte B étant plus simple que la porte Q, il est facile, par un dimensionnement convenable des transistors MOS utilisés, d'obtenir que la porte B transite plus rapidement que la porte Q.

On remarquera encore que la transition à $v_{DD}$ de la porte Q est elle-même rapide puisque cette porte est tirée à "1" (soit $v_{DD}$) à travers un seul transistor canal P (le transistor B) et non à travers deux tels transistors, comme c'est le cas pour la porte A du circuit de la figure 1B.

Dans certaines circonstances, on dispose automatiquement d'une entrée inversée, $\bar{I}_0$ par exemple. Il est alors possible de réduire encore le nombre des transistors constituant un multiplexeur suivant l'invention, comme représenté aux figures 3A, 3B. Le multiplexeur représenté à la figure 3 comprend des portes élémentaires 3, 5 et 6 identiques aux portes 3, 5 et 6 respectivement du multiplexeur de la figure 2A et interconnectées de la même manière. L'alimentation du circuit de la figure 3A par une entrée $\bar{I}_0$ plutôt que $I_0$ permet de supprimer l'inverseur que l'on trouve sur la figure 2A, et donc deux transistors, comme cela apparaît sur la topographie de transistors de la figure 3B, identique pour le reste à celle de la figure 2B.

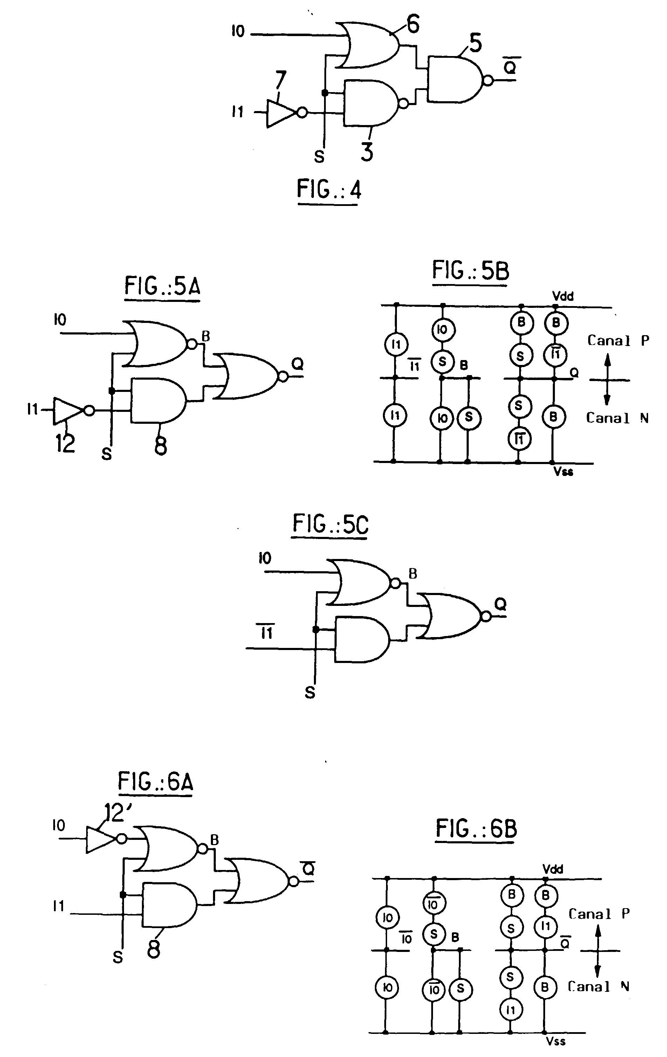

Dans d'autres circonstances, on souhaite disposer d'une sortie inversée $\bar{Q}$, plutôt que de la sortie Q vraie. Le multiplexeur représenté à la figure 4 répond à cette situation. Il comprend des portes 3, 5, 6 identiques aux portes 3, 5, 6 du multiplexeur de la figure 2, et un inverseur 7 placé cette fois sur l'entrée de la porte NAND 3 qui reçoit normalement $I_1$. Un tel circuit compte treize transistors. Comme précédemment, si l'on dispose naturellement de $\bar{I}_1$, on peut réduire ce nombre à onze grâce à la suppression de l'inverseur 7.

Bien entendu les formes duales de toute topographie de multiplexeur suivant l'invention peuvent constituer elles-mêmes un tel multiplexeur. A titre d'exemple, on a ainsi représenté à la figure 5A le circuit dual du circuit de la figure 2. Le circuit de la figure 5A comprend une première porte B du type NOR alimentée par $I_0$ et S et une deuxième porte constituée d'une porte 8 du type AND (ET) alimentée par $I_1$ et S, la sortie de cette porte étant combinée avec la sortie de la porte B dans une autre porte NOR délivrant la sortie Q.

La topographie de ce circuit est représentée à la figure 5B. Elle se déduit de celle de la figure 2B par échange des inverseurs donnant $\overline{I}_0$ et $\overline{I}_1$ et échange des topographies des groupes de transistors canal N et canal P. Cette structure à treize transistors MOS peut encore être réduite à onze si, comme représenté à la figure 5C, on dispose naturellement de l'entrée $\overline{I}_1$, qui permet de se passer de l'inverseur 12 de la figure 5A.

Les structures des figures 5A et 5C peuvent naturellement être déclinées pour former d'autres structures telles que celles représentées à la figure 6A qui délivrent $\overline{Q}$ au lieu de Q. Cette dernière structure est composée de portes 8, B et $\overline{Q}$ identiques aux portes 8, B et Q de la structure de la figure 5A. Elle comprend un inverseur 12' sur l'entrée de la porte B qui reçoit $I_0$. Une topographie de transistors permettant de réaliser cette structure est représentée à la figure 6B. On y trouve les deux transistors $I_0$ constituant l'inverseur 12', les transistors canal P S et $\overline{I}_0$ en série et les transistors canal N $\overline{I}_0$ et S en parallèle de la porte B, et enfin les transistors canal P B et S en série dans une branche en parallèle avec une branche contenant B et $I_1$ et le transistor canal N B en parallèle avec une branche contenant des transistors S et $I_1$, constituant la porte $\overline{Q}$. On pourrait réduire le nombre de transistors de cette topographie de 13 à 12 en remplaçant dans la porte $\overline{Q}$ les deux transistors B par un seul, comme représenté à la figure 2C, ou même à 10 si l'on dispose directement de $\overline{I}_0$.

La présente invention permet de réaliser, plus généralement, des multiplexeurs comprenant plus de deux entrées logiques, par exemple $2^n$, n étant un entier supérieur à 1, un tel multiplexeur étant constitué par une arborescence à n étages de multiplexeurs à deux entrées suivant l'invention. Les multiplexeurs du ième étage sont commandés classiquement par le ième bit $S_i$ d'un mot de commande $(S_0 S_1 \ldots S_1 \ldots S_{n-1})$ de n bits assurant la sélection d'une entrée particulière à transmettre à la sortie Q du multiplexeur.

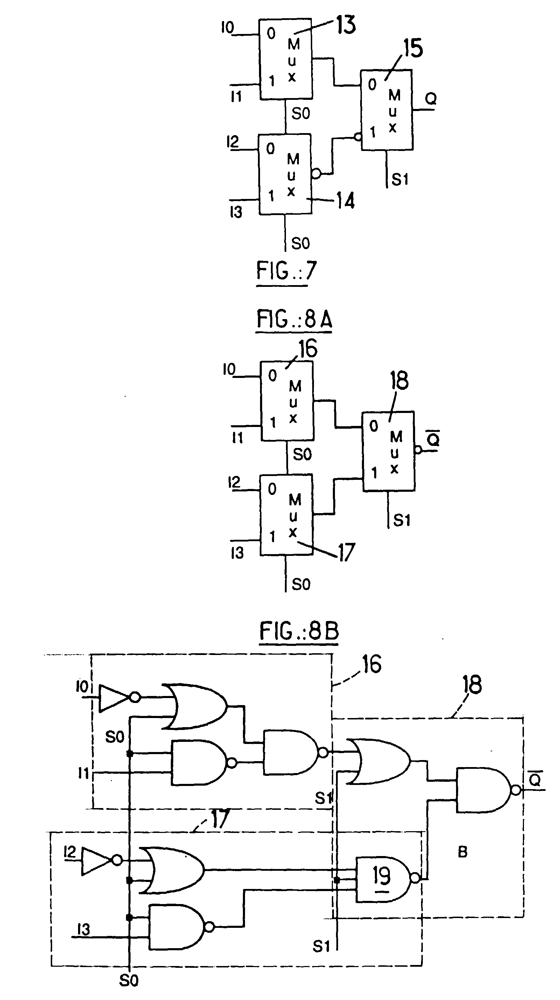

A titre d'exemple, la figure 7 illustre la structure d'un multiplexeur à quatre (n = 2) entrées $I_0, I_1, I_2, I_3$ suivant l'invention, commandé par un mot $(S_0 S_1)$. Il comprend deux étages de multiplexeurs à deux entrées, le premier étage comprenant des multiplexeurs 13,14 d'entrées $(I_0, I_1)$ et $(I_2, I_3)$ respectivement, commandés par le bit $S_0$ du mot de commande et le deuxième étage étant constitué par un multiplexeur unique 15 dont les entrées sont raccordées aux sorties des deux multiplexeurs du premier étage, la sortie du multiplexeur 15 constituant celle du multiplexeur à quatre entrées.

Suivant un mode de réalisation de ce multiplexeur, les multiplexeurs à deux entrées 13, 14 et 15 peuvent être constitués par ceux représentés aux figures 2, 4 et 5C, respectivement. La topographie de l'ensemble compte alors 37 transistors MOS.

On a représenté aux figures 8A,8B un autre mode de réalisation d'un multiplexeur à quatre entrées suivant l'invention, qui délivre une sortie complémentée $\overline{Q}$ utile dans certaines applications, comme on l'a vu plus haut. Comme représenté à la figure 8A, un tel multiplexeur peut être constitué par trois multiplexeurs à deux entrées 16, 17 et 18 dont les deux premiers sont conformes à celui de la figure 2 et le troisième à celui de la figure 4.

La figure 8B représente l'agencement de portes d'une variante du multiplexeur de la figure 8A, qui permet de réduire le nombre de transistors nécessaires. Pour ce faire la porte NAND 19 est commune aux multiplexeurs 17 et 18 et compte alors trois entrées. La topographie de transistors CMOS nécessaire pour réaliser un tel multiplexeur compte alors trente six transistors seulement dans un schéma exclusivement constitué de branches parallèles, et même trente deux transistors seulement si on renonce à cette contrainte.

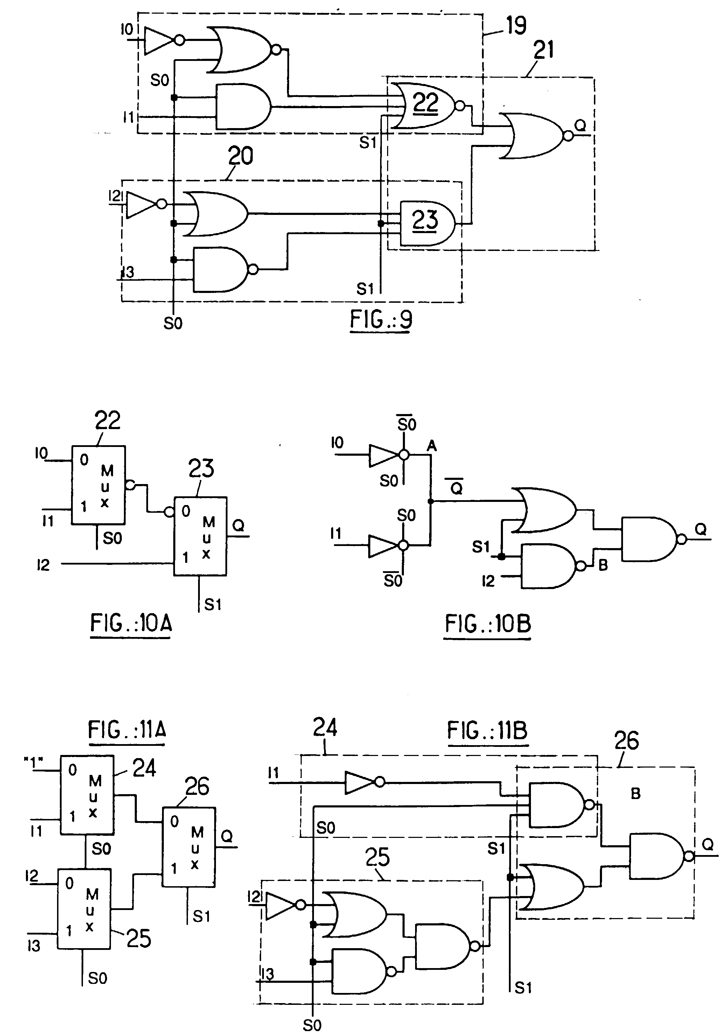

La figure 9 représente un agencement de portes d'un multiplexeur à quatre entrées $I_0$ à $I_3$, qui va dans le sens d'une nouvelle réduction du nombre des transistors CMOS nécessaires. On reconnaît dans cet agencement trois multiplexeurs 19, 20, 21 respectivement conformes à ceux représentés aux figures 6A, 2 et 5C. Le multiplexeur 21 de sortie comprend une porte NOR 22 commune avec le multiplexeur 19 et une porte AND 23 commune avec le multiplexeur 20. La topographie de transistors CMOS nécessaire pour réaliser un tel multiplexeur à quatre entrées compte trente six transistors dans un schéma constitué exclusivement de branches parallèles. Si on renonce à cette contrainte, la topographie compte trente transistors seulement.

Les figures 10A, 10B montrent qu'on peut combiner un multiplexeur à deux entrées suivant l'invention avec des multiplexeurs classiques, pour constituer un multiplexeur à trois entrées $I_0, I_1, I_2$, par exemple. Comme représenté à la figure 10A, ce multiplexeur comprend un multiplexeur 22 à deux entrées $I_0, I_1$ et un autre multiplexeur 23 à deux entrées, constituées par la sortie du multiplexeur 22 et l'entrée $I_2$. Comme représenté sur la figure 10B, le multiplexeur 22 peut être du type C2MOS classique représenté à la figure 1, à deux inverseurs commandés par des signaux de commande S, $\overline{S}$, sans inversion de sa sortie qui alimente alors une porte OR d'un multiplexeur 23 du type représenté à la figure 3A. La non-inversion de cette sortie économise deux transistors MOS et l'ensemble compte ainsi 21 transistors (10+11) au lieu de 23.

On a représenté à la figure 11A le schéma général d'un multiplexeur à trois entrées suivant l'invention, obtenu à partir d'un schéma de multiplexeur à quatre entrées dans lequel une des entrées, $I_0$ par exemple, est fixée ou "câblée" à "1". On retrouve sur le schéma logique de la figure 11B, les trois multiplexeurs 24,25,26 à deux entrées de la figure 11A. Si les multiplexeurs 25 et 26 sont du type de celui de la figure 2, le "multiplexeur" 24 se réduit à un inverseur 27 alimentant une entrée de la porte NAND 28 commune aux multiplexeurs 24 et 26. Cette structure logique peut ainsi être réalisée avec vingt huit transistors en technologie CMOS.

Il apparaît maintenant que l'invention permet de constituer des multiplexeurs, à deux entrées ou plus, qui peuvent être optimisés par rapport aux caractéristiques antagonistes que sont la consommation électrique et la fréquence de fonctionnement d'une part, et en ce qui concerne la compacité des topographies de transistors à utiliser pour réaliser de tels multiplexeurs. On notera en particulier l'amélioration de la rapidité qui résulte de la suppression de l'inversion du signal de commande et l'utilisation de topographies essentiellement "en branches" parallèles pour améliorer la compacité de ces topographies, favorable à l'abaissement de la consommation électrique. Les multiplexeurs suivant l'invention se prêtent à une incorporation dans une "librairie" de circuits de base, utilisables de manière systématique par des concepteurs de circuits intégrés, notamment à basse consommation électrique.

Bien entendu l'invention n'est pas limitée aux modes de réalisation décrits et représentés, qui n'ont été donnés qu'à titre d'exemple. C'est ainsi que la présente invention couvre aussi des multiplexeurs à nombre d'entrées supérieur à 4 et toute forme duale non représentée des topographies décrites, de tels multiplexeurs et formes duales pouvant être établis sans effort par l'homme de métier à partir des enseignements contenus dans la présente description, et couverts par les revendications.

## Revendications

1. Multiplexeur (figures 2B et 2C) réalisé sous la forme d'un circuit intégré à transistors CMOS, à deux entrées ($I_0, \overline{I}_0$ ; $I_1, \overline{I}_1$) de variables logiques et une sortie ($Q, \overline{Q}$), du type comprenant des première et deuxième portes logiques alimentées chacune par une des entrées, la première porte appliquant une première fonction logique élémentaire à une des variables d'entrée et à une variable logique de commande (S) du multiplexeur, chacune desdites portes étant formée par un premier groupe de transistors d'un premier type de conduction et d'un deuxième groupe de transistors d'un deuxième type de conduction, ces deux groupes de transistors étant montés en série entre les bornes ($V_{DD}, V_{SS}$) d'une source de tension d'alimentation et leur point de connexion commun formant le noeud de sortie de la porte, les chemins de conduction des transistors étant montés en série et/ou parallèle à l'intérieur de chaque groupe de sorte que l'état de conduction de ces transistors détermine le potentiel du noeud de sortie de la porte qui représente la variable fournie par cette porte et qui peut prendre des valeurs sensiblement égales à celles des deux bornes ($V_{SS}$, $V_{DD}$) de la source d'alimentation, les potentiels ($V_{DD}$) et ($V_{SS}$) étant lus chacun comme représentant l'un de deux états logiques, chaque transistor étant commandé par une variable interne (B), par la variable de commande (S) du multiplexeur ou par les variables d'entrée ($I_0, \overline{I}_0$ ; $I_1, \overline{I}_1$),

- caractérisé en ce que la deuxième porte applique une fonction logique équivalant d'une part à une deuxième fonction logique élémentaire à l'autre variable d'entrée et à la même variable de commande (S) et, d'autre part, à la première fonction logique à la sortie (B) de la première porte et au résultat de l'application de la deuxième fonction logique pour constituer la variable de sortie ($Q, \overline{Q}$) du multiplexeur,

- et en ce qu'il comprend les circuits logiques suivants, désignés respectivement par la variable A, B et Q qu'ils délivrent et composés des transistors indiqués pour chaque groupe, chacun des transistors désigné par la variable qui le commande, la connexion des chemins de conduction de ces transistors étant indiquée dans chaque groupe par "série" ou "parallèle" et un montage indiqué entre crochets étant à considérer dans son ensemble :

- inverseur A : premier groupe $I_0$, deuxième groupe $I_0$

- porte B : premier groupe S parallèle $I_1$, deuxième groupe S série $I_1$

- porte Q : premier groupe [A série S] parallèle B deuxième groupe [A série B] parallèle [B série S], le transistor B pouvant être commun aux deux chemins de conduction du deuxième groupe.

2. Multiplexeur (figure 5B) réalisé sous la forme d'un circuit intégré à transistors CMOS, à deux entrées ($I_0, \overline{I}_0$ ; $I_1, \overline{I}_1$) de variables logiques et une sortie ($Q, \overline{Q}$), du type comprenant des première et deuxième portes logiques alimentées chacune par une des entrées, la première porte appliquant une première fonction logique élémentaire à une des variables d'entrée et à une variable logique de commande (S) du multiplexeur, chacune desdites portes étant formée par un premier groupe de transistors d'un premier type de conduction et d'un deuxième groupe de transistors d'un deuxième type de conduction, ces deux groupes de transistors étant montés en série entre les bornes ($V_{DD}, V_{SS}$) d'une source de tension d'alimentation et leur point de connexion commun formant le noeud de sortie de la porte, les chemins de conduction des transistors étant montés en série et/ou parallèle à l'intérieur de chaque groupe de sorte que l'état de conduction de ces transistors détermine le potentiel du noeud de sortie de la porte qui représente la variable fournie par cette porte et qui peut prendre des valeurs sensiblement égales à celles des deux bornes ($V_{SS}$, $V_{DD}$) de la source d'alimentation, les potentiels ($V_{DD}$) et ($V_{SS}$) étant lus chacun comme représentant l'un de deux états logiques, chaque transistor étant commandé par une variable interne (B), par la variable de commande (S) du multiplexeur ou par les variables d'entrée ($I_0$, $\overline{I}_0$ ; $I_1$, $\overline{I}_1$),

- caractérisé en ce que la deuxième porte applique une fonction logique équivalant d'une part à une deuxième fonction logique élémentaire à l'autre variable d'entrée et à la même variable de commande (S) et, d'autre part, à la première fonction logique à la sortie (B) de la première porte et au résultat de l'application de la deuxième fonction logique pour constituer la variable de sortie (Q, $\overline{Q}$) du multiplexeur,
- et en ce qu'il comprend les circuits logiques suivants, désignés respectivement par la variable $\overline{I}_1$, B et Q qu'ils délivrent et composée des transistors indiqués pour chaque groupe, chacun des transistors désigné par la variable qui le commande, la connexion des chemins de conduction de ces transistors étant indiquée dans chaque groupe par "série" ou "parallèle" et un montage indiqué entre crochets étant à considérer dans son ensemble :
- inverseur $\overline{I}_1$ : premier groupe $I_1$, deuxième groupe $I_1$
- porte B : premier groupe $I_0$ série S, deuxième groupe $I_0$ parallèle S
- porte Q : premier groupe [B série S] parallèle [B série $\overline{I}_1$], le transistor B pouvant être commun aux deux chemins de conduction, deuxième groupe [S série $\overline{I}_1$] parallèle B.

3. Multiplexeur (figure 3B) réalisé sous la forme d'un circuit intégré à transistors CMOS, à deux entrées ($I_0$, $\overline{I}_0$ ; $I_1$, $\overline{I}_1$) de variables logiques et une sortie (Q, $\overline{Q}$), du type comprenant des première et deuxième portes logiques alimentées chacune par une des entrées, la première porte appliquant une première fonction logique élémentaire à une des variables d'entrée et à une variable logique de commande (S) du multiplexeur, chacune desdites portes étant formée par un premier groupe de transistors d'un premier type de conduction et d'un deuxième groupe de transistors d'un deuxième type de conduction, ces deux groupes de transistors étant montés en série entre les bornes ($V_{DD}$, $V_{SS}$) d'une source de tension d'alimentation et leur point de connexion commun formant le noeud de sortie de la porte, les chemins de conduction des transistors étant montés en série et/ou parallèle à l'intérieur de chaque groupe de sorte que l'état de conduction de ces transistors détermine le potentiel du noeud de sortie de la porte qui représente la variable fournie par cette porte et qui peut prendre des valeurs sensiblement égales à celles des deux bornes ($V_{SS}$, $V_{DD}$) de la source d'alimentation, les potentiels ($V_{DD}$) et ($V_{SS}$) étant lus chacun comme représentant l'un de deux états logiques, chaque transistor étant commandé par une variable interne (B), par la variable de commande (S) du multiplexeur ou par les variables d'entrée ($I_0$, $\overline{I}_0$ ; $I_1$, $\overline{I}_1$),

- caractérisé en ce que la deuxième porte applique une fonction logique équivalant d'une part à une deuxième fonction logique élémentaire à l'autre variable d'entrée et, à la même variable de commande (S) et, d'autre part, à la première fonction logique à la sortie (B) de la première porte et au résultat de l'application de la deuxième fonction logique pour constituer la variable de sortie (Q, $\overline{Q}$) du multiplexeur,
- et en ce qu'il comprend les portes logiques B et Q suivantes, désignées respectivement par la variable qu'elles délivrent et composées de transistors indiqués pour chaque groupe, chacun des transistors désigné par la variable qui le commande, la connexion des chemins de conduction de ces transistors étant indiquée dans chaque groupe par "série" ou "parallèle" et un montage indiqué entre crochets étant à considérer dans son ensemble :
- porte B : premier groupe S parallèle $I_1$ deuxième groupe S série $I_1$
- porte Q : premier groupe [$\overline{I}_0$ série S] parallèle B deuxième groupe, [$\overline{I}_0$ série B] parallèle [S série B] ou [$\overline{I}_0$ parallèle S] série B.

4. Multiplexeur (figure 6B) réalisé sous la forme d'un circuit intégré à transistors CMOS, à deux entrées ($I_0$, $\overline{I}_0$ ; $I_1$, $\overline{I}_1$) de variables logiques et une sortie (Q, $\overline{Q}$), du type comprenant des première et deuxième portes logiques alimentées chacune par une des entrées, la première porte appliquant une première fonction logique élémentaire à une des variables d'entrée et à une variable logique de commande (S) du multiplexeur, chacune desdites portes étant formée par un premier groupe de transistors d'un premier type de conduction et d'un deuxième groupe de transistors d'un deuxième type de conduction, ces deux groupes de transistors étant montés en série entre les bornes (VDD, Vss) d'une source de tension d'alimentation et leur point de connexion commun formant le noeud de sortie de la porte, les chemins de conduction des transistors étant montés en série et/ou parallèle à l'intérieur de chaque groupe de sorte que l'état de conduction de ces transistors détermine le potentiel du noeud de sortie de la porte qui représente la variable fournie par cette porte et qui peut prendre des valeurs sensiblement égales à celles des deux bornes ($V_{SS}$, $V_{DD}$) de la source d'alimentation, les potentiels ($V_{DD}$) et ($V_{SS}$) étant lus chacun comme représentant l'un de deux états logiques, chaque transistor étant commandé par une variable interne (B), par la variable de commande (S) du multiplexeur ou par les variables d'entrée ($I_0$, $\overline{I}_0$ ; $I_1$, $\overline{I}_1$),

- caractérisé en ce que la deuxième porte applique une fonction logique équivalant d'une part à une deuxième fonction logique élémentaire à l'autre variable d'entrée et à la même variable de commande (S) et, d'autre part, à la première fonction logique à la sortie (B) de la première porte et au résultat de l'application de la deuxième fonction logique pour constituer la variable de sortie ($Q$, $\overline{Q}$) du multiplexeur,

- et en ce qu'il comprend les circuits logiques suivants, désignés respectivement par la variable $\overline{I}_0$, B et Q qu'ils délivrent et composés des transistors indiqués pour chaque groupe, chacun des transistors désigné par la variable qui le commande, la connexion des chemins de conduction de ces transistors étant indiquée dans chaque groupe par "série" ou "parallèle" et un montage indiqué entre crochets étant à considérer dans son ensemble :

- inverseur $\overline{I}_0$ : premier groupe $I_0$, deuxième groupe $I_0$

- porte B : premier groupe S série $\overline{I}_0$
    deuxième groupe S parallèle $\overline{I}_0$

- porte $\overline{Q}$ : premier groupe [B série S] parallèle [B série $I_1$], le transistor B pouvant être commun aux deux chemins de conduction
    deuxième groupe : [S série $I_1$] parallèle B.

5. Multiplexeur de $2^n$ entrées logiques ($I_0$, $I_1$..$I_{2n-1}$) vers une sortie (Q,Q), comprenant n étages, avec n > 1, de multiplexeurs à deux entrées, les multiplexeurs d'un même étage (i) étant commandés par le ième bit d'un mot de commande ($S_0$,...$S_{n-1}$) de n bits et ces multiplexeurs étant connectés suivant une arborescence, caractérisé en ce qu'il comprend au moins un multiplexeur conforme à l'une quelconque des revendications 1 à 4.

6. Multiplexeur conforme à la revendication 5, dans lequel n = 2, caractérisé en ce qu'il comprend un premier étage de deux multiplexeurs en parallèle, à deux entrées chacun et dont les sorties sont connectées aux entrées d'un multiplexeur unique formant l'étage de sortie, les sorties des deux multiplexeurs du premier étage étant vraie et inversée, respectivement, la sortie inversée étant connectée à une entrée inverseuse du multiplexeur de sortie.

7. Multiplexeur conforme à l'une quelconque des revendications 5 et 6, caractérisé en ce qu'au moins une porte logique élémentaire est partagée entre deux multiplexeurs appartenant à deux étages consécutifs.

8. Multiplexeur conforme à la revendication 5, caractérisé en ce qu'il est constitué par une structure à deux étages de multiplexeurs à deux entrées et une sortie, l'une des entrées d'un des multiplexeurs de l'étage recevant les entrées étant câblée à "1", de manière à constituer un multiplexeur à trois entrées.

## Patentansprüche

1. Multiplexer (Fig. 2B und 2C) in Form einer integrierten Schaltung von CMOS-Transistoren, mit zwei Eingängen ($I_0$, $\overline{I}_0$; $I_1$, $\overline{I}_1$) für logische Größen und einem Ausgang (Q, $\overline{Q}$) einer Bauart, welche erste und zweite logische Gatter aufweist, die jeweils von einem der Eingänge gespeist werden, wobei das erste Gatter eine erste logische Grundfunktion auf eine der Eingangsgrößen und eine logische Steuerungsgröße (S) des Multiplexers anwendet, wobei jedes der Gatter von einer ersten Gruppe von Transistoren einer ersten Leitungsart und einer zweiten Gruppe von Transistoren einer zweiten Leitungsart gebildet wird, wobei diese beiden Transistorgruppen zwischen den Anschlüssen ($V_{DD}$, $V_{SS}$) einer Versorgungsspannungsquelle und ihrem gemeinsamen Verbindungspunkt, der den Ausgangsknoten des Gatters bildet, in Reihe geschaltet sind, wobei die Leitungsbahnen der Transistoren im Inneren jeder Gruppe in Reihe und/oder parallel geschaltet sind, so daß der Leitungszustand dieser Transistoren das Potential am Ausgangsknoten des Gatters bestimmt, welches die von diesem Gatter gelieferte Größe darstellt und welches Werte annehmen kann, die im wesentlichen gleich denen der beiden Anschlüsse ($V_{SS}$, $V_{DD}$) der Versorgungsquelle sind, wobei die Potentiale ($V_{DD}$) und ($V_{SS}$) als repräsentativ für einen der beiden Logikzustände gelesen werden, und wobei jeder Transistor durch eine interne Größe (B) und durch die Steuerungsgröße (S) des Multiplexers oder durch die Eingangsgrößen ($I_0$, $\overline{I}_0$; $I_1$, $\overline{I}_1$) gesteuert wird,

- dadurch gekennzeichnet, daß das zweite Gatter eine entsprechende logische Funktion einerseits einer zweiten logischen Grundfunktion aus der anderen Eingangsgröße und derselben Steuerungsgröße (S) und andererseits der ersten logischen Funktion am Ausgang (B) des ersten Gatters und als Folge der Anwendung der zweiten logischen Funktion bewirkt, um die

Ausgangsgröße (Q, $\overline{Q}$) des Multiplexers zu bilden,

- und daß er die folgenden logischen Schaltungen aufweist, welche durch die von ihnen abgegebene Größen A, B. bzw. Q bezeichnet sind und aus für jede Gruppe indizierten Transistoren zusammengesetzt sind, von denen jeder durch die ihn steuernde Größe bezeichnet ist, wobei die Verbindung der Leitungsbahnen dieser Transistoren in jeder Gruppe durch "Reihe" oder "parallel" indiziert ist und eine zwischen eckigen Klammern indizierte Anordnung in seiner Gesamtheit zu betrachten ist:

- Inverter A: erste Gruppe $I_0$, zweite Gruppe $I_0$
- Gatter B: erste Gruppe S parallel zu $I_1$, zweite Gruppe S in Reihe mit $I_1$
- Gatter Q: erste Gruppe [A in Reihe mit S] parallel zu B

  zweite Gruppe [A in Reihe mit B] parallel zu [B in Reihe mit S], wobei der Transistor B beiden Leitungsbahnen der zweiten Gruppe gemeinsam sein kann.

2. Multiplexer (Fig. 5B) in Form einer integrierten Schaltung von CMOS-Transistoren, mit zwei Eingängen ($I_0, \overline{I}_0$; $I_1, \overline{I}_1$) für logische Größen und einem Ausgang (Q, $\overline{Q}$) einer Bauart, welche erste und zweite logische Gatter aufweist, die jeweils von einem der Eingänge gespeist werden, wobei das erste Gatter eine erste logische Grundfunktion auf eine der Eingangsgrößen und eine logische Steuerungsgröße (S) des Multiplexers anwendet, wobei jedes der Gatter von einer ersten Gruppe von Transistoren einer ersten Leitungsart und einer zweiten Gruppe von Transistoren einer zweiten Leitungsart gebildet wird, wobei diese beiden Transistorgruppen zwischen den Anschlüssen ($V_{DD}$, $V_{SS}$) einer Versorgungsspannungsquelle und ihrem gemeinsamen Verbindungspunkt, der den Ausgangsknoten des Gatters bildet, in Reihe geschaltet sind, wobei die Leitungsbahnen der Transistoren im Inneren jeder Gruppe in Reihe und/oder parallel geschaltet sind, so daß der Leitungszustand dieser Transistoren das Potential am Ausgangsknoten des Gatters bestimmt, welches die von diesem Gatter gelieferte Größe darstellt und welches Werte annehmen kann, die im wesentlichen gleich denen der beiden Anschlüsse ($V_{SS}$, $V_{DD}$) der Versorgungsquelle sind, wobei die Potentiale ($V_{DD}$) und ($V_{SS}$) als repräsentativ für einen der beiden Logikzustände gelesen werden, und wobei jeder Transistor durch eine interne Größe (B) und durch die Steuerungsgröße (S) des Multiplexers oder durch die Eingangsgrößen ($I_0, \overline{I}_0$; $I_1, \overline{I}_1$) gesteuert wird,

- dadurch gekennzeichnet, daß das zweite Gatter eine entsprechende logische Funktion einerseits einer zweiten logischen Grundfunktion

aus der anderen Eingangsgröße und derselben Steuerungsgrößen (S) und andererseits der ersten logischen Funktion am Ausgang (B) des ersten Gatters und als Folge der Anwendung der zweiten logischen Funktion bewirkt, um die Ausgangsgröße (Q, $\overline{Q}$) des Multiplexers zu bilden,

- und daß er die folgenden logischen Schaltungen aufweist, welche durch die von ihnen abgegebene Größe $\overline{I}_1$, B. bzw. Q bezeichnet sind und aus für jede Gruppe indizierten Transistoren zusammengesetzt sind, von denen jeder durch die ihn steuernde Größe bezeichnet ist, wobei die Verbindung der Leitungsbahnen dieser Transistoren in jeder Gruppe durch "Reihe" oder "parallel" indiziert ist und eine zwischen eckigen Klammern indizierte Anordnung in ihrer Gesamtheit zu betrachten ist:

- Inverter $\overline{I}_1$: erste Gruppe $I_1$, zweite Gruppe $I_1$
- Gatter B: erste Gruppe $I_0$ in Reihe mit S, zweite Gruppe $I_0$ parallel zu S
- Gatter Q: erste Gruppe [B in Reihe mit S] parallel zu [B in Reihe mit $\overline{I}_1$], wobei der Transistor (B) beiden Leitungsbahnen der zweiten Gruppe gemeinsam sein kann,

  zweite Gruppe [S in Reihe mit $\overline{I}_1$] parallel zu B.

3. Multiplexer (Fig. 3B) in Form einer integrierten Schaltung von CMOS-Transistoren, mit zwei Eingängen ($I_0, \overline{I}_0$; $I_1, \overline{I}_1$) für logische Größen und einem Ausgang (Q, $\overline{Q}$) einer Bauart, welche erste und zweite logische Gatter aufweist, die jeweils von einem der Eingänge gespeist werden, wobei das erste Gatter eine erste logische Grundfunktion auf eine der Eingangsgrößen und eine logische Steuerungsgröße (S) des Multiplexers anwendet, wobei jedes der Gatter von einer ersten Gruppe von Transistoren einer ersten Leitungsart und einer zweiten Gruppe von Transistoren einer zweiten Leitungsart gebildet wird, wobei diese beiden Transistorgruppen zwischen den Anschlüssen ($V_{DD}$, $V_{SS}$) einer Versorgungsspannungsquelle und ihrem gemeinsamen Verbindungspunkt, der den Ausgangsknoten des Gatters bildet, in Reihe geschaltet sind, wobei die Leitungsbahnen der Transistoren im Inneren jeder Gruppe in Reihe und/oder parallel geschaltet sind, so daß der Leitungszustand dieser Transistoren das Potential am Ausgangsknoten des Gatters bestimmt, welches die von diesem Gatter gelieferte Größe darstellt und welches Werte annehmen kann, die im wesentlichen gleich denen der beiden Anschlüsse ($V_{SS}$, $V_{DD}$) der Versorgungsquelle sind, wobei die Potentiale ($V_{DD}$) und ($V_{SS}$) als repräsentativ für einen der beiden Logikzustände gelesen werden, und wobei jeder Transistor durch eine interne Größe (B) und durch die Steuerungsgröße (S) des Multiplexers oder durch die Eingangsgrößen ($I_0, \overline{I}_0$; $I_1, \overline{I}_1$) gesteuert wird,

- dadurch gekennzeichnet, daß das zweite Gatter eine entsprechende logische Funktion einerseits einer zweiten logischen Grundfunktion, aus der anderen Eingangsgröße und derselben Steuerungsgröße (S) und andererseits der ersten logischen Funktion am Ausgang (B) des ersten Gatters und als Folge der Anwendung der zweiten logischen Funktion bewirkt, um die Ausgangsgröße $(Q, \overline{Q})$ des Multiplexers zu bilden,

- und daß er die folgenden logischen Gatter aufweist, welche durch die von ihnen abgegebene Größe B und Q bezeichnet sind und aus für jede Gruppe indizierten Transistoren zusammengesetzt sind, von denen jeder durch die ihn steuernde Größe bezeichnet ist, wobei die Verbindung der Leitungsbahnen dieser Transistoren in jeder Gruppe durch "Reihe" oder "parallel" indiziert ist und eine zwischen eckigen Klammern indizierte Anordnung in ihrer Gesamtheit zu betrachten ist:

- Gatter B: erste Gruppe S parallel zu $I_1$, zweite Gruppe S in Reihe mit $I_1$

- Gatter Q: erste Gruppe $[\overline{I}_0$ in Reihe mit S] parallel zu B
  zweite Gruppe $[\overline{I}_0$ in Reihe mit B] parallel zu [S in Reihe mit B],
  oder $[\overline{I}_0$ parallel zu S] in Reihe mit B.

4. Multiplexer (Fig. 6B) in Form einer integrierten Schaltung von CMOS-Transistoren, mit zwei Eingängen $(I_0, \overline{I}_0 ; I_1, \overline{I}_1)$ für logische Größen und einem Ausgang $(Q, \overline{Q})$ einer Bauart, welche erste und zweite logische Gatter aufweist, die jeweils von einem der Eingänge gespeist werden, wobei das erste Gatter eine erste logische Grundfunktion auf eine der Eingangsgrößen und eine logische Steuerungsgröße (S) des Multiplexers anwendet, wobei jedes der Gatter von einer ersten Gruppe von Transistoren einer ersten Leitungsart und einer zweiten Gruppe von Transistoren einer zweiten Leitungsart gebildet wird, wobei diese beiden Transistorgruppen zwischen den Anschlüssen $(V_{DD}, V_{SS})$ einer Versorgungsspannungsquelle und ihrem gemeinsamen Verbindungspunkt, der den Ausgangsknoten des Gatters bildet, in Reihe geschaltet sind, wobei die Leitungsbahnen der Transistoren im Inneren jeder Gruppe in Reihe und/oder parallel geschaltet sind, so daß der Leitungszustand dieser Transistoren das Potential am Ausgangsknoten des Gatters bestimmt, welches die von diesem Gatter gelieferte Größe darstellt und welches Werte annehmen kann, die im wesentlichen gleich denen der beiden Anschlüsse $(V_{SS}, V_{DD})$ der Versorgungsquelle sind, wobei die Potentiale $(V_{DD})$ und $(V_{SS})$ als repräsentativ für einen der beiden Logikzustände gelesen werden, und wobei jeder Transistor durch eine interne Größe (B) und durch die Steuerungsgröße (S) des Multiplexers oder durch die Eingangsgrößen $(I_0, \overline{I}_0 ; I_1, \overline{I}_1)$ gesteuert wird,

- dadurch gekennzeichnet, daß das zweite Gatter eine entsprechende logische Funktion einerseits einer zweiten logischen Grundfunktion aus der anderen Eingangsgrößen und derselben Steuerungsgröße (S) und andererseits der ersten logischen Funktion am Ausgang (B) des ersten Gatters und als Folge der Anwendung der zweiten logischen Funktion bewirkt, um die Ausgangsgröße $(Q, \overline{Q})$ des Multiplexers zu bilden,

- und daß er die folgenden logischen Schaltungen aufweist, welche durch die von ihnen abgegebene Größe $\overline{I}_0$, B. bzw. Q bezeichnet sind und aus für jede Gruppe indizierten Transistoren zusammengesetzt sind, von denen jeder durch die ihn steuernde Größe bezeichnet ist, wobei die Verbindung der Leitungsbahnen dieser Transistoren in jeder Gruppe durch "Reihe" oder "parallel" indiziert ist und eine zwischen eckigen Klammern indizierte Anordnung in ihrer Gesamtheit zu betrachten ist:

- Inverter $\overline{I}_0$ : erste Gruppe $I_0$, zweite Gruppe $I_0$

- Gatter B: erste Gruppe S in Reihe mit $\overline{I}_0$, zweite Gruppe S in Reihe mit $\overline{I}_0$

- Gatter $\overline{Q}$: erste Gruppe [B in Reihe mit S] parallel zu [B in Reihe mit $I_1$],
  wobei der Transistor B beiden Leitungsbahnen der zweiten Gruppe gemeinsam sein kann,
  zweite Gruppe [S in Reihe mit $I_1$] parallel zu B.

5. Multiplexer mit $2^n$ logischen Eingängen $(I_0, I_1 \ldots I_{2n-1})$ auf einen Ausgang $(Q, \overline{Q})$, welcher n Stufen mit n > 1 Multiplexern mit jeweils zwei Eingängen aufweist, wobei die Multiplexer einer gemeinsamen Stufe (i) von dem soundsovielten Bit eines Steuerungswortes $(S_0, \ldots S_{n-1})$, bestehend aus n Bits, gesteuert werden und diese Multiplexer baumartig verbunden sind, dadurch gekennzeichnet, daß er mindestens einen Multiplexer gemäß einem der Ansprüche 1 bis 4 aufweist.

6. Multiplexer nach Anspruch 5, bei dem n = 2 ist, dadurch gekennzeichnet, daß er eine erste Stufe aus zwei Multiplexern aufweist, die parallel geschaltet und jeweils mit zwei Eingängen versehen sind und deren Ausgänge an den Eingängen eines die Ausgangsstufe bildenden einzigen Multiplexers angeschlossen sind, wobei die Ausgänge der beiden Multiplexer der ersten Stufe nicht invertierend bzw. invertierend sind, wobei der invertierende Ausgang mit einem invertierenden Eingang des Ausgangsmultiplexers verbunden ist.

7. Multiplexer nach einem der Ansprüche 5 und 6, dadurch gekennzeichnet, daß mindestens ein logisches Grundgatter zwischen zwei Multiplexern, die zu zwei aufeinanderfolgenden Stufen gehören, aufgeteilt ist.

8. Multiplexer nach Anspruch 5, dadurch gekennzeichnet, daß er von einer Anordnung aus zwei Stufen von Multiplexern mit zwei Eingängen und einem Ausgang gebildet wird, wobei der eine der Eingänge eines der Multiplexer der die Eingänge empfangenden Stufe mit "1" so verkabelt ist, daß ein Multiplexer mit drei Eingängen gebildet wird.

**Claims**

1. A multiplexer (figures 2B and 2C) implemented as a CMOS integrated circuit with two inputs ($I_0$, $\overline{I}_0$, $I_1$, $\overline{I}_1$) for logic variables and one output (Q, $\overline{Q}$), of the type comprising first and second logic gates each fed with one of the inputs, wherein the first gate applies a first elementary logic function to one of the input variables and to a multiplexer control logic variable (S), each of said logic gates being formed by a first group of transistors with a first type of conduction and by a second group of transistors with a second type of conduction, these two groups of transistors being mounted in series between the terminals ($V_{DD}$, $V_{SS}$) of a power supply voltage source and their common connection point forming the output node of the gate, the conduction paths of the transistors being mounted in series and/or in parallel within each group in such a way that the state of conduction of these transistors determines the potential of the output node of the gate which represents the variable supplied by this gate and which can take values substantially equal to those of the two terminals ($V_{DD}$, $V_{SS}$) of the power supply source, the potentials ($V_{DD}$) and ($V_{SS}$) each being read as representing one of the two logic states, each transistor being controlled by an internal variable (B), by the multiplexer control variable (S) or by the input variables ($I_0$, $\overline{I}_0$, $I_1$, $\overline{I}_1$),

- characterized in that the second gate applies a function equivalent, on the one hand, to a second elementary logic function to the other input variable and to the same control variable (S) and, on the other hand, to the first logic function to the output (B) of the first gate and to the result of the application of the second logic function, so as to constitute the multiplexer output variable (Q, $\overline{Q}$).
- and in that it comprises the following logic circuits, designated respectively by the variable A, B and Q which they deliver and consisting of the transistors indicated for each group, each of the transistors designated by the variable which controls it, the connection of the conduction paths of these transistors being indicated in each group by "series" or "parallel" and a mounting indicated between square brackets having to be considered in its entirety:

- inverter A: first group $I_0$, second group $I_0$
- gate B: first group S, $I_1$ parallel, second group S, $I_1$ series
- gate Q: first group [A, S series], B parallel, second group [A, B series], [B, S series] parallel, the transistor B possibly being common to the two conduction paths of the second group.

2. The multiplexer (figure 5B) implemented as a CMOS integrated circuit with two inputs ($I_0$, $\overline{I}_0$, $I_1$, $\overline{I}_1$) for logic variables and one output (Q, $\overline{Q}$), of the type comprising first and second logic gates each fed with one of the inputs, wherein the first gate applies a first elementary logic function to one of the input variables and to a multiplexer control logic variable (S), each of said logic gates being formed by a first group of transistors with a first type of conduction and by a second group of transistors with a second type of conduction, these two groups of transistors being mounted in series between the terminals ($V_{DD}$, $V_{SS}$) of a power supply voltage source and their common connection point forming the output node of the gate, the conduction paths of the transistors being mounted in series and/or in parallel within each group in such a way that the state of conduction of these transistors determines the potential of the output node of the gate which represents the variable supplied by this gate and which can take values substantially equal to those of the two terminals ($V_{DD}$, $V_{SS}$) of the power supply source, the potentials ($V_{DD}$) and ($V_{SS}$) each being read as representing one of the two logic states, each transistor being controlled by an internal variable (B), by the multiplexer control variable (S) or by the input variables ($I_0$, $\overline{I}_0$, $I_1$, $\overline{I}_1$),

- characterized in that the second gate applies a function equivalent, on the one hand, to a second elementary logic function to the other input variable and to the same control variable (S) and, on the other hand, to the first logic function to the output (B) of the first gate and to the result of the application of the second logic function, so as to constitute the multiplexer output variable (Q, $\overline{Q}$),
  
  and in that it comprises the following logic circuits, designated respectively by the variable $\overline{I}_1$, B and Q which they deliver and consisting of the transistors indicated for each group, each of the transistors designated by the variable which controls it, the connection of the conduction paths of these transistors being indicated in each group by "series" or "parallel", and a mounting indicated between square brackets having to be considered in its entirety:

- inverter $\overline{I}_1$: first group $I_1$, second group $I_1$
- gate B: first group $\overline{I}_0$, S series, second group $\overline{I}_0$, S parallel
- gate Q: first group [B, S series], [B, $\overline{I}_1$ series] parallel, the transistor B possibly being common to the two conduction paths, second group [S, $\overline{I}_1$ series], B parallel.

3. The multiplexer (figure 3B) implemented as a CMOS integrated circuit with two inputs ($I_0$, $\overline{I}_0$, $I_1$, $\overline{I}_1$) for logic variables and one output (Q, $\overline{Q}$), of the type comprising first and second logic gates each fed with one of the inputs, wherein the first gate applies a first elementary logic function to one of the input variables and to a multiplexer control logic variable (S), each of said logic gates being formed by a first group of transistors with a first type of conduction and by a second group of transistors with a second type of conduction, these two groups of transistors being mounted in series between the terminals ($V_{DD}$, $V_{SS}$) of a power supply voltage source and their common connection point forming the output node of the gate, the conduction paths of the transistors being mounted in series and/or in parallel within each group in such a way that the state of conduction of these transistors determines the potential of the output node of the gate which represents the variable supplied by this gate and which can take values substantially equal to those of the two terminals ($V_{DD}$, $V_{SS}$) of the power supply source, the potentials ($V_{DD}$) and ($V_{SS}$) each being read as representing one of the two logic states, each transistor being controlled by an internal variable (B), by the multiplexer control variable (S) or by the input variables ($I_0$, $\overline{I}_0$, $I_1$, $\overline{I}_1$),

  - characterized in that the second gate applies a function equivalent, on the one hand, to a second elementary logic function to the other input variable and to the same control variable (S) and, on the other hand, to the first logic function to the output (B) of the first gate and to the result of the application of the second logic function, so as to constitute the multiplexer output variable (Q, $\overline{Q}$),
  - and in that it comprises the following logic gates B and Q, designated respectively by the variable which they deliver and consisting of transistors indicated for each group, each transistor designated by the variable which controls it, the connection of the conduction paths of these transistors being indicated in each group by "series" or "parallel", and a mounting indicated between square brackets having to be considered in its entirety:

- gate B: first group S, $\overline{I}_1$ parallel
    second group S, $I_1$ series
- gate Q: first group [ Io, S series], B parallel,
    second group, [$\overline{I}_0$, B series] [S, B series]
    or [$\overline{I}_0$, S parallel], parallel, B series.

4. The multiplexer (figure 6B) implemented as a CMOS integrated circuit with two inputs ($I_0$, $\overline{I}_0$, $I_1$, $\overline{I}_1$) for logic variables and one output (Q, Q), of the type comprising first and second logic gates each fed with one of the inputs, wherein the first gate applies a first elementary logic function to one of the input variables and to a multiplexer control logic variable (S), each of said logic gates being formed by a first group of transistors with a first type of conduction and by a second group of transistors with a second type of conduction, these two groups of transistors being mounted in series between the terminals ($V_{DD}$, $V_{SS}$) of a power supply voltage source and their common connection point forming the output node of the gate, the conduction paths of the transistors being mounted in series and/or in parallel within each group in such a way that the state of conduction of these transistors determines the potential of the output node of the gate which represents the variable supplied by this gate and which can take values substantially equal to those of the two terminals ($V_{DD}$, $V_{SS}$) of the power supply source, the potentials ($V_{DD}$) and ($V_{SS}$) each being read as representing one of the two logic states, each transistor being controlled by an internal variable (B), by the multiplexer control variable (S) or by the input variables ($I_0$, $\overline{I}_0$, $I_1$, $\overline{I}_1$),

  - characterized in that the second gate applies a function equivalent, on the one hand, to a second elementary logic function to the other input variable and to the same control variable (S) and, on the other hand, to the first logic function to the output (B) of the first gate and to the result of the application of the second logic function, so as to constitute the multiplexer output variable (Q, $\overline{Q}$),
  - and in that it further comprises the following logic circuits designated respectively by the variable $\overline{I}_0$, B and $\overline{Q}$ which they deliver and consisting of the transistors indicated for each group, each transistor designated by the variable which controls it, the connection of the conduction paths of these transistors being indicated in each group by "series" or "parallel", and a mounting indicated between square brackets having to be considered in its entirety:
  - inverter $\overline{I}_0$: first group $\overline{I}_0$, second group $I_0$
  - gate B: first group S, $\overline{I}_0$ series
      second group S, $\overline{I}_0$ parallel
  - gate Q: first group [B, S series], [B, $\overline{I}_1$ series] parallel, the transistor B possibly being common to the two conduction paths

second group: $[S, \overline{I}_1 \text{ series}]$, B parallel.

5. A multiplexer of $2^n$ logic inputs $(I_0, I_1, \dots I_{2n-1})$ to one output $(Q, \overline{Q})$, comprising n stages, with $n > 1$, of two-input multiplexers, the multiplexers of any one stage (i) being controlled by the ith bit of an n-bit control word $(S_0, \dots S_{n-1})$, and these multiplexers being connected in a tree structure, characterized in that it comprises at least one multiplexer as claimed in any one of claims 1 to 4.

6. The multiplexer as claimed in claim 5, in which n=2, charaterized in that it comprises a first stage of two multiplexers in parallel, each with two inputs and the outputs of which are connected to the inputs of a single multiplexer forming the output stage, the outputs of the two multiplexers of the first stage being true and inverted, respectively, the inverted output being connected to a inverting input of the output multiplexer.

7. The multiplexer as claimed in any one of claims 5 and 6, characterized in that at least one elementary logic gate is shared between two multiplexers belonging to two consecutive stages.

8. The multiplexer as claimed in claim 5, characterized in that it consists of a structure with two stages of multiplexers with two inputs and one output, one of the inputs of one of the multiplexers of the stage receiving the inputs being hard-wired to "1", so as to constitute a three-input multiplexer.

## FIG.:1A

(TECHNIQUE ANTERIEURE)

## FIG.:1B

## FIG.:2A

## FIG.:2B

## FIG.:2C

## FIG.:3A

## FIG.:3B

13

EP 0 709 963 B1

FIG.: 4

FIG.:5A

FIG.:5B

FIG.:5C

FIG.:6A

FIG.:6B

14

FIG.:7

FIG.:8 A

FIG.:8B

FIG.:9

FIG.:10A

FIG.:10B

FIG.:11A

FIG.:11B